(19) Europäisches Patentamt
European Patent Office
Office européen des brevets

(11) **EP 2 096 687 A1**

(12) **EUROPEAN PATENT APPLICATION**
published in accordance with Art. 153(4) EPC

(43) Date of publication:
02.09.2009 Bulletin 2009/36

(51) Int Cl.:
*H01L 35/22* [(2006.01)] *C04B 35/50* [(2006.01)]

(21) Application number: 07849967.0

(86) International application number:
PCT/JP2007/073262

(22) Date of filing: 26.11.2007

(87) International publication number:
WO 2008/066189 (05.06.2008 Gazette 2008/23)

(84) Designated Contracting States:
AT BE BG CH CY CZ DE DK EE ES FI FR GB GR HU IE IS IT LI LT LU LV MC MT NL PL PT RO SE SI SK TR

(30) Priority: 28.11.2006 JP 2006319695

(71) Applicant: **Sumitomo Chemical Company, Limited Tokyo 104-8260 (JP)**

(72) Inventors:
• **UCHIDA, Yoshio**
  **Tsukuba-shi**
  **Ibaraki 305-0045 (JP)**

• **TOHMA, Tetsuro**
  **Niihama-shi**
  **Ehime 792-0009 (JP)**
• **SADAOKA, Kazuo**
  **Tsukuba-shi**
  **Ibaraki 305-0821 (JP)**

(74) Representative: **Hart-Davis, Jason et al**
  **Cabinet Beau de Loménie,**
  **158, rue de l'Université**
  **75340 Paris Cedex 07 (FR)**

(54) **THERMOELECTRIC CONVERSION MATERIAL AND THERMOELECTRIC CONVERSION ELEMENT**

(57) The present invention provides a thermoelectric conversion material with stable thermoelectric conversion properties such as power factor in air at high temperature. The thermoelectric conversion material comprises a mixed metal oxide comprising $M^1$, $M^{2A}$ and $M^{2B}$ as metal elements at a molar ratio of $M^1:M^{2A}:M^{2B}$ of 2:1:1 and having a perovskite crystal structure, wherein $M^1$ represents at least one $M^{1A}$ selected from the group consisting of La, Y and lanthanoid elements, or a combination of $M^{1A}$ and at least one $M^{1B}$ selected from among alkaline earth metal elements, $M^{2A}$ represents at least one selected from the group consisting of metal elements each of which can have an atomic valence of 2, $M^{2B}$ represents at least one selected from the group consisting of metal elements each of which can have an atomic valence of 4, $M^1$, $M^{2A}$ and $M^{2B}$ are different from one another, and each of $M^{2A}$ and $M^{2B}$ may contain a doping element.

Fig. 1

**Description**

TECHNICAL FIELD

The present invention relates to a thermoelectric conversion material and a thermoelectric conversion device.

BACKGROUND ART

Thermoelectric conversion power generation is power generation of converting thermal energy into electric energy, utilizing Seebeck effect by which thermal electromotive force is generated by applying a temperature difference between thermoelectric conversion materials. Thermoelectric conversion power generation is expected as environment-conservative electrical power generation since it is capable of utilizing earth's heat or exhaust heat such as heat from incinerators as a thermal energy.

An efficiency of converting thermal energy into electric energy of the thermoelectric conversion material (hereinafter, referred to as "energy conversion efficiency") depends on figure of merit (Z) of the thermoelectric conversion material. The figure of merit (Z) is determined according to the equation (1) using the Seebeck coefficient ($\alpha$), electric conductivity ($\sigma$) and thermal conductivity ($\kappa$) of the thermoelectric conversion material.

$$Z = \alpha^2 \times \sigma / \kappa \quad (1)$$

If a thermoelectric conversion material having large figure of merit (Z) is used, a thermoelectric conversion device of excellent energy conversion efficiency is obtained. $\alpha^2 \times \sigma$ in the equation (1) is called a power factor (PF), and larger this value of a thermoelectric conversion material, output becomes higher per unit temperature of a thermoelectric conversion device.

The thermoelectric conversion material includes a p-type thermoelectric conversion material having a positive Seebeck coefficient and an n-type thermoelectric conversion material having a negative Seebeck coefficient. Usually, a thermoelectric conversion device having a p-type thermoelectric conversion material and an n-type thermoelectric conversion material connected electrically serially is used, in thermoelectric conversion power generation. The energy conversion efficiency of the thermoelectric conversion device depends on the figure of merit (Z) of the p-type thermoelectric conversion material and the n-type thermoelectric conversion material. For obtaining a thermoelectric conversion device excellent in energy conversion efficiency, a p-type thermoelectric conversion material and an n-type thermoelectric conversion material having a large figure of merit (Z) are required.

For example, JP-A 2001-512910 (p.2-8) discloses a thermoelectric conversion material represented by $RBa_2Cu_3O_{7-\delta}$.

The thermoelectric conversion material described in this publication, however, does not have thermoelectric conversion properties (e.g., power factor) which are stable and excellent under operating ambient conditions of air at high temperature (approximately 600°C).

DISCLOSURE OF THE INVENTION

The present invention has an object of providing a material showing thermoelectric conversion properties which are stable and excellent under operating ambient conditions.

The present inventors have variously investigated and resultantly completed the present invention.

That is, the present invention provides a thermoelectric conversion material comprising a mixed metal oxide comprising $M^1$, $M^{2A}$ and $M^{2B}$ as metal elements at a molar ratio of $M^1:M^{2B}:M^{2B}$ of 2:1:1 and having a perovskite crystal structure,
wherein $M^1$ represents at least one $M^{1A}$ selected from the group consisting of La, Y and lanthanoid elements, or a combination of $M^{1A}$ and at least one $M^{1B}$ selected from among alkaline earth metal elements,
$M^{2A}$ represents at least one selected from the group consisting of metal elements each of which can have an atomic valence of 2,
$M^{2B}$ represents at least one selected from the group consisting of metal elements each of which can have an atomic valence of 4,
$M^1$, $M^{2A}$ and $M^{2B}$ are different from one another, and each of $M^{2A}$ and $M^{2B}$ may contain a doping element.

Further, the present invention provides a thermoelectric conversion device containing the above-described thermoelectric conversion material.

BRIEF EXPLANATION OF DRAWING

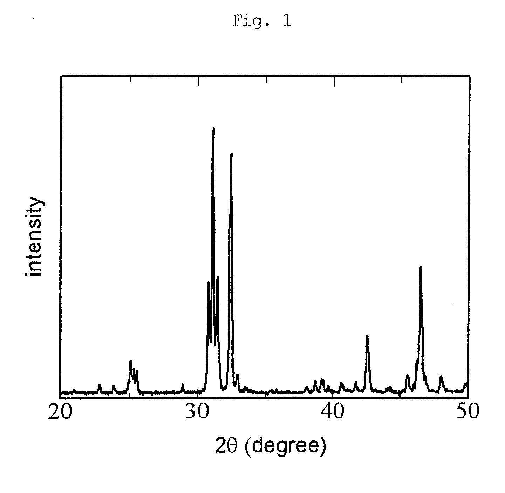

Fig. 1 shows an X-ray diffraction pattern of a sintered body 1 in Example 1.

MODES FOR CARRYING OUT THE INVENTION

**Thermoelectric conversion material**

The thermoelectric conversion material of the present invention contains a mixed metal oxide. The mixed metal oxide contains $M^1$, $M^{2A}$ and $M^{2B}$ as metal elements.

$M^1$ is $M^{1A}$, or a combination of $M^{1A}$ and $M^{1B}$. $M^{1A}$ may be advantageously selected from the group consisting of La, Y and lanthanoid elements, and preferable are metal elements each of which can have an atomic valence of 3 among them. $M^{1A}$ represents usually La, Y, Ce, Pr, Nd, Pm, Sm, Eu or Gd, preferably La. These may be used singly or in combination with another or more. $M^{1B}$ represents an alkaline earth metal element, preferably Ca, Sr or Ba. These may be used singly or in combination with another or more. When $M^1$ is a combination of $M^{1A}$ and $M^{1B}$, the amount of $M^{1B}$ is usually 1:0.01 to 1:1 in terms of the molar ratio of $M^{1A}:M^{1B}$.

$M^{2A}$ represents a metal element which can have an atomic valence of 2, preferably Cu, Ni, Zn or Ag, more preferably Cu. These may be used singly or in combination with another or more. $M^{2A}$ may also be a combination of metal elements each of which can have an atomic valence of 2 and metal elements having an atomic valence of other than 2 (doping element I, for example, Li, Na, Al, Ga, In, Bi, Sb), and a part of the former may be substituted by the latter. A thermoelectric conversion material containing such a doping element I may have high thermoelectric conversion properties.

$M^{2B}$ represents a metal element which can have an atomic valence of 4, preferably Ti, V, Cr, Mn, Fe, Co, Zr, Nb, Mo, Tc, Ru, Os, Ir, Pt, Au or Sn, more preferably Sn, Ti or Mn. These may be used singly or in combination with another or more. $M^{2B}$ may also be a combination of metal elements each of which can have an atomic valence of 4 and metal elements having an atomic valence of other than 4 (doping element II, for example, Mg, Ca, Cu, Ni, Zn, Ag, Sc, Al, Ga, In, Bi, Sb), and a part of the former may be substituted by the latter. Also a thermoelectric conversion material containing such a doping element II may have high thermoelectric conversion properties, likewise.

$M^1$, $M^{2A}$ and $M^{2B}$ are different from one another. For example, when $M^1$ is a combination of $M^{1A}$ and $M^{1B}$, $M^{2A}$ does not contain a metal element $M^{1B}$. For example, when $M^{2A}$ is divalent Sn, $M^{2B}$ does not contain tetravalent Sn.

The molar ratio of $M^1:M^{2A}:M^{2B}$ is 2:1:1.

The mixed metal oxide has a perovskite crystal structure.

Specific examples of the mixed metal oxide are shown below.

Examples of the mixed metal oxide in which $M^{1A}$ is La include:

$La_2CuSnO_6$ ($M^{2A}$ is Cu, $M^{2B}$ is Sn),
$La_2CuTiO_6$ ($M^{2A}$ is Cu, $M^{2B}$ is Ti),
$La_2NiSnO_6$ ($M^{2A}$ is Ni, $M^{2B}$ is Sn),
$La_2ZnSn0_6$ ($M^{2A}$ is Zn, $M^{2B}$ is Sn),
$La_2ZnTiO_6$ ($M^{2A}$ is Zn, $M^{2B}$ is Ti),
$La_2ZnZrO_6$ ($M^{2A}$ is Zn, $M^{2B}$ is Zr),
$La_{2-x}Ca_xCu_2Sn_2O_{11}$ ($M^{1B}$ is Ca, $M^{2A}$ is Cu, $M^{2B}$ is Sn, $0.01{\leq}x/(2-x){\leq}1$),
$La_{2-x}Ca_xCu_2Ti_2O_n$ ($M^{1B}$ is Ca, $M^{2A}$ is Cu, $M^{2B}$ is Ti, $0.01{\leq}x/(2-x){\leq}1$),
$La_{2-x}Ca_xZn_2Sn_2O_n$ ($M^{1B}$ is Ca, $M^{2A}$ is Zn, $M^{2B}$ is Sn, $0.01{\leq}x/(2-x){\leq}1$),
$La_{2-x}Ca_xZn_2Ti_2O_n$ ($M^{1B}$ is Ca, $M^{2A}$ is Zn, $M^{2B}$ is Ti, $0.01{\leq}x/(2-x){\leq}1$),
$La_{2-x}Ca_xNi_2Sn_2O_{11}$ ($M^{1B}$ is Ca, $M^{2A}$ is Ni, $M^{2B}$ is Sn, $0.01{\leq}x/(2-x){\leq}2$)
$La_{2-x}Ba_xCu_2Sn_2O_{11}$ ($M^{1B}$ は Ba, $M^{2A}$ is Cu, $M^{2B}$ is Sn, $0.01{\leq}x/(2-x){\leq}1$),
$La_{2-x}Ba_xCu_2Ti_2O_{11}$ ($M^{1B}$ は Ba, $M^{2A}$ is Cu, $M^{2B}$ is Ti, $0.01{\leq}x/(2-x){\leq}1$),
$La_{2-x}Ba_xZn_2Sn_2O_{11}$ ($M^{1B}$ は Ba, $M^{2A}$ is Zn, $M^{2B}$ is Sn, $0.01{\leq}x/(2-x){\leq}1$),
$La_{2-x}Ba_xZn_2Ti_2O_{11}$ ($M^{1B}$ は Ba, $M^{2A}$ is Zn, $M^{2B}$ is Ti, $0.01{\leq}x/(2-x){\leq}1$),
$La_{2-x}Ba_xNi_2Sn_2O_{11}$ ($M^{1B}$ は Ba, $M^{2A}$ is Ni, $M^{2B}$ is Sn, $0.01{\leq}x/(2-x){\leq}1$),
$La_{2-x}Sr_xCu_2Sn_2O_{11}$ ($M^{1B}$ is Sr, $M^{2A}$ is Cu, $M^{2B}$ is Sn, $0.01{\leq}x/(2-x){\leq}1$),
$La_{2-x}Sr_xCu_2Ti_2O_{11}$ ($M^{1B}$ is Sr, $M^{2A}$ is Cu, $M^{2B}$ is Ti, $0.01{\leq}x/(2-x){\leq}1$),
$La_{2-x}Sr_xZn_2Sn_2O_{11}$ ($M^{1B}$ is Sr, $M^{2A}$ is Zn, $M^{2B}$ is Sn, $0.01{\leq}x/(2-x){\leq}1$),
$La_{2-x}Sr_xZn_2Ti_2O_{11}$ ($M^{1B}$ is Sr, $M^{2A}$ is Zn, $M^{2B}$ is Ti, $0.01{\leq}x/(2-x){\leq}1$),
$La_{2-x}Sr_xN1_2Sn_2O_{11}$ ($M^{1B}$ is Sr, $M^{2A}$ is Ni, $M^{2B}$ is Sn, $0.01{\leq}x/(2-x){\leq}1$).

The mixed metal oxide in which $M^{1A}$ represents a metal element which can have an atomic valence of 3 other than La (Y, Ce, Pr, Nd, Pm, Sm, Eu, Gd) is an oxide obtained by substituting La by these metal elements, and examples of the mixed metal oxide in which $M^{1A}$ is Eu include:

$Eu_2CuSnO_6$ ($M^{2A}$ is Cu, $M^{2B}$ is Sn)
$Eu_2CuTiO_6$ ($M^{2A}$ is Cu, $M^{2B}$ is Ti)
$Eu_2NiSnO_6$ ($M^{2A}$ is Ni, $M^{2B}$ is Sn)
$Eu_2ZnSnO_6$ ($M^{2A}$ is Zn, $M^{2B}$ is Sn)
$Eu_2ZnTiO_6$ ($M^{2A}$ is Zn, $M^{2B}$ is Ti)
$Eu_2ZnZrO_6$ ($M^{2A}$ is Zn, $M^{2B}$ is Zr)
$Eu_2Ba_2Cu_2Sn_2O_{11}$ ($M^{1B}$ is Ba, $M^{2A}$ is Cu, $M^{2B}$ is Sn)
$Eu_2Ba_2Cu_2Ti_2O_{11}$ ($M^{1B}$ is Ba, $M^{2A}$ is Cu, $M^{2B}$ is Ti)
$Eu_2Ba_2Zn_2Sn_2O_{11}$ ($M^{1B}$ is Ba, $M^{2A}$ is Zn, $M^{2B}$ is Sn)
$Eu_2Ba_2Zn_2Ti_2O_{11}$ ($M^{1B}$ is Ba, $M^{2A}$ is Zn, $M^{2B}$ is Ti)
$Eu_2Ba_2Ni_2Sn_2O_{11}$ ($M^{1B}$ is Ba, $M^{2A}$ is Ni, $M^{2B}$ is Sn).

Y, Ce, Pr, Nd, Pm, Sm, Eu and Gd can be used in substitution as described above since each of them can have an atomic valence of 3 and has an ion radius which is approximately the same as that of La, and the resultant thermoelectric conversion material also performs an analogous effect.

Examples of the mixed metal oxide in which 40% of La is substituted by Eu include:

$(La_{0.6}Eu_{0.4})_2CuSnO_6$, $(La_{0.6}Eu_{0.4})_2CuTiO_6$, $(La_{0.6}Eu_{0.4})_2NiSnO_6$, $(La_{0.6}Eu_{0.4})_2ZnSnO_6$, $(La_{0.6}Eu_{0.4})_2ZnTiO_6$, $(La_{0.6}Eu_{0.4})_2ZnZrO_6$, $(La_{0.6}Eu_{0.4})_2Ba_2CU_2Sn_2O_{11}$, $(La_{0.6}Eu_{0.4})_2Ba_2Cu_2Ti_2O_{11}$, $(La_{0.6}Eu_{0.4})_2Ba_2Zn_2Sn_2O_{11}$, $(La_{0.6}Eu_{0.4})_2Ba_2Zn_2Ti_2O_{11}$, $(La_{0.6}Eu_{0.4})_2Ba_2Ni_2Sn_2O_{11}$.

The thermoelectric conversion material has a form of, for example, powder, sintered body or thin film, and preferably sintered body. When the form of the thermoelectric conversion material is a sintered body, it is advantageous that the shape and dimension thereof are appropriate as a thermoelectric conversion device, and the shape is, for example, plate, circular cylinder or rectangular cylinder.

The thermoelectric conversion material is preferably a dense material from the standpoint of electric conductivity (σ) and mechanical strength, and the relative density thereof is preferably not less than 60%, more preferably not less than 80%, further preferably not less than 90%. Such a thermoelectric conversion material has typically a shape of oriented sintered body or single crystal.

When thermoelectric conversion material has a possibility of showing decrease in performance by oxidation or reduction under operating ambient conditions, its surface may be coated with a gas barrier film. The gas barrier film is composed of, for example, alumina, titania, zirconia, or silicon carbide. The gas barrier film is advantageously one which covers the surface or part thereof within the range not deteriorating the function of the thermoelectric conversion material.

The thermoelectric conversion material of the present invention may be advantageously produced by a sintering method, and for example, it may be advantageously produced by a method in which a mixture of metals or metal oxides is sintered. The mixture may be advantageously prepared by a method in which metals or metal compounds are weighed and mixed so as to provide a given composition.

The thermoelectric conversion material may be advantageously produced, specifically, by a method in which a compound containing $M^1$, a compound containing $M^{2A}$ and a metal compound containing $M^{2B}$ are weighed and mixed to prepare a mixture satisfying the molar ratio of $M^1$:$M^{2A}$:$M^{2B}$ of 2:1:1, and the mixture is sintered, and the mixed metal oxide represented by $Y_2CuSnO_6$ may be advantageously produced by a method in which yttrium oxide ($Y_2O_3$), copper oxide (CuO) and tin oxide ($SnO_2$) are used as metal compounds, and these compounds are weighed and mixed so that the molar ratio of Y:Cu:Sn satisfies 2:1:1, to obtain a mixture and the mixture is sintered.

The metal compound is a compound containing a metal element represented by $M^1$, $M^{2A}$ or $M^{2B}$, and examples thereof include hydroxides, carbonates, nitrates, halides, sulfates and organic acid salts which are decomposed and/or oxidized at high temperature to become oxides, or oxides.

The thermoelectric conversion material may also be produced, for example, by a method in which a compound containing $M^{1A}$, a compound containing $M^{2A}$ and a metal compound containing $M^{2B}$ are weighed and mixed to prepare a mixture satisfying the molar ratio of $M^{1A}$:$M^{2A}$:$M^{2B}$ of 2:1:1, and the mixture is sintered, and in this case, $M^{1A}$ is La, $M^{2A}$ is Cu and $M^{2B}$ is Sn. The compound containing La is, for example, lanthanum oxide, lanthanum hydroxide or lanthanum nitrate, preferably, lanthanum oxide. The compound containing Cu is, for example, copper(I) oxide, copper(II) oxide or copper nitrate, preferably, copper(II) oxide, and the compound containing Sn is, for example, tin oxide, tin nitrate or tin chloride, preferably, tin oxide.

It is advantageous that the mixing is carried out using, for example, ball mill, V-shape mixer, vibration mill, attritor, dyno mill or dynamic mill. The mixing may be carried out either in dry mode or wet mode. The mixing is preferably carried out by a method for obtaining a uniform mixture of metal oxides from the standpoint of obtaining an excellent thermoelectric conversion material.

The mixture may contain additives such as a binder, dispersant and releasing agent. The additive may be added in mixing the compound, or may be added to the mixture, or a sintered body or pulverized body described later. The mixture may be, if necessary, calcined. When the mixture contains hydroxides, carbonates, nitrates, halides, organic acid salts and the like which are decomposed and/or oxidized at high temperature to become oxides, the calcination can be carried out, to change them into oxides, or remove a carbon dioxide gas and crystal water from them, further, to improve uniformity of the composition of the sintered body or uniformity of the structure of the sintered body, and to suppress deformation of the sintered body. The calcination may be advantageously carried out by setting conditions appropriately depending on the composition of the mixture, and for example, when the mixture contains a carbonate, the calcination may be advantageously carried out under conditions of temperature: not less than 600°C and not more than 1200°C, atmosphere: air, holding time: 5 to 24 hours. The mixture may be pulverized. The pulverizing may be advantageously carried out using, for example, ball mill, vibration mill, attritor, dyno mill or dynamic mill. The mixture may be formed. The formation may be advantageously carried out under conditions giving a shape suitable as a thermoelectric conversion device, such as plate, rectangular cylinder, and circular cylinder. The formation may be advantageously carried out using, for example, uniaxial press, cold isostatic press (CIP), mechanical press, hot press or hot isobaric press (HIP).

The thermoelectric conversion material is preferably produced by a method in which a mixture, calcined body or pulverized body is formed, and the resultant is sintered, and further preferably produced by a method in which a mixture is calcined, pulverized, then, formed, and the resultant is sintered.

The sintering may be advantageously carried out under conditions of temperature: not less than 700°C and not more than 1700°C, preferably not less than 900°C and not more than 1500°C, further preferably not less than 1000°C and not more than 1400°C, holding time: 0.5 to 48 hours, and atmosphere: air, oxygen, vacuum or inert gas (nitrogen, rare gas). When the sintering temperature is less than 700°C, sintering is difficult, and depending on the composition of the mixed metal oxide, the electric conductivity ($\sigma$) of thermoelectric conversion material may decrease. In contrast, when the sintering temperature is over 1500°C, abnormal grain growth and melting occur, and the figure of merit (Z) of the thermoelectric conversion material may decrease, depending on the composition of the mixed metal oxide.

The sintered body may be pulverized, if necessary, and the pulverized body may be sintered. The sintering may be advantageously carried out under the same conditions as described above.

The thermoelectric conversion material may be advantageously produced by a method in which the mixture is calcined and pulverized, and the resultant pulverized body is formed and sintered simultaneously by HIP.

In the production of the thermoelectric conversion material, the relative density of the sintered body can be controlled by altering the particle size of a mixture, calcined body or pulverized body, or molding pressure, sintering temperature, sintering time and the like.

When thermoelectric conversion material has a possibility of showing decrease in performance by oxidation or reduction under operating ambient conditions, its surface may be coated with a gas barrier film through which a gas does not permeate easily. The gas barrier film is composed of, for example, alumina, titania, zirconia, or silicon carbide. The coating may be advantageously carried out by, for example, aerosol deposition, thermal spray or CVD (chemical vapor deposition).

Thermoelectric conversion material may also be produced by other methods. Examples of the other methods include methods including a coprecipitation step, a hydrothermal step, a dry up step, a sputtering step, a step of CVD, a sol gel step, a FZ (floating zone melting) step or a step of TSCG (template type single crystal growth).

**Thermoelectric conversion device**

The thermoelectric conversion device contains the above-described thermoelectric conversion material.

Since the thermoelectric conversion material is usually p-type, the thermoelectric conversion device contains the p-type thermoelectric conversion material and an n-type thermoelectric conversion material. As the n-type thermoelectric conversion material, for example, $Zn_{0.98}Al_{0.02}O$ or $SrTiO_3$ may be used (see, JP-A 8-186293, JP-A 8-231223). The thermoelectric conversion device may be advantageously fabricated so as to give a structure disclosed, for example, in JP-A 5-315657.

EXAMPLES

The present invention will be illustrated further in detail by examples, but the scope of the present invention is not limited to them. The properties of the thermoelectric conversion material were measured as follows.

Crystal structure

The crystal structure of a sample (calcined body, sintered body) was determined by powder X-ray diffractometry using an X-ray diffractometer (trade name: RINT2500TTR, manufactured by Rigaku Corporation) with a radiation source: CuKα.

Seebeck coefficient (α, μV/K)

A sample (sintered body) was processed into rectangular cylinder to obtain a specimen. A R thermocouple and platinum line were provided on the both ends of the specimen, using a silver paste, and the temperatures of the specimen and the thermal electromotive force were measured in air at room temperature to 1073 K. A glass tube through which air was flowing was brought into contact with one end surface of the specimen to cool the specimen to make a low temperature part. At this stage, the temperatures of the both end surfaces were measured by the R thermocouple, and simultaneously, the thermal electromotive force ($\Delta V$) generated between the both end surfaces of the specimen was measured. The temperature difference ($\Delta T$) between the both ends of the specimen was controlled in the range of 1 to 10°C by controlling the flow rate of air. The Seebeck coefficient ($\alpha$) was calculated from inclinations of $\Delta T$ and $\Delta V$.

Electric conductivity (σ, S/m)

A platinum line was provided on a specimen using a silver paste, the specimen being obtained by the same manner as for measurement of Seebeck coefficient, and the electric conductivity was measured by a direct current four-point probe method in air at room temperature to 1073 K.

Thermal conductivity (κ, W/mK)

The thermal conductivity of a sample (sintered body) was measured by a laser flushing method using a thermal conductivity measurement apparatus (trade name: TC-7000, manufactured by Sinku-Riko Inc.) at room temperature (measurement temperature).

Relative density (%)

The relative density of a sample (sintered body) was determined by the Archimedes method.

Example 1

3.074 g of CuO (Manufactured by Kojundo Chemical Laboratory Co., Ltd.), 5.825 g of SnO$_2$ (Manufactured by Kojundo Chemical Laboratory Co., Ltd.) and 12.593 g of La$_2$O$_3$ (Manufactured by Kojundo Chemical Laboratory Co., Ltd.) were weighed and mixed for 20 hours using a wet ball mill with zirconia ball media. The mixture was calcined in air at 1100°C for 24 hours and pulverized for 20 hours using a wet ball mill with zirconia ball media to obtain a powder. The powder was formed using a uniaxial press (molding pressure: 1000 kg/cm$^2$) to obtain a disk-shaped green body. The green body was sintered for 24 hours under an atmosphere of 100% oxygen at 1100°C to obtain a sintered body 1. The properties of the sintered body 1 were shown in Table 1. The X-ray diffraction pattern of the sintered body 1 was shown in Fig. 1. The sintered body 1 had a relative density of 95%, and a thermal conductivity at room temperature (approximately 25°C) of 5.61 W/mK.

Example 2

The same operation as in Example 1 was carried out excepting that 1.537 g of CuO (Manufactured by Kojundo Chemical Laboratory Co., Ltd.), 2.912 g of SnO$_2$ (Manufactured by Kojundo Chemical Laboratory Co., Ltd.), 6.139 g of La$_2$O$_3$ (Manufactured by Kojundo Chemical Laboratory Co., Ltd.) and 0.097 g of CaCO$_3$ (trade name: CS3N-A, manufactured by Ube Material Industries) were used as raw materials, to obtain a sintered body 2. The properties of the sintered body 2 were shown in Table 1. The sintered body 2 had a thermal conductivity at room temperature (approximately 25°C) of 3.63 W/mK.

Example 3

The same operation as in Example 1 was carried out excepting that 1.537 g of CuO (Manufactured by Kojundo Chemical Laboratory Co., Ltd.), 2.912 g of SnO$_2$ (Manufactured by Kojundo Chemical Laboratory Co., Ltd.), 6.139 g of

La$_2$O$_3$ (Manufactured by Kojundo Chemical Laboratory Co., Ltd.) and 0.191 g of BaCO$_3$ (trade name: LC-1, manufactured by Nippon Chemical Industrial Co., Ltd.) were used as raw materials to obtain a sintered body 3. The properties of the sintered body 3 were shown in Table 1. The sintered body 3 had a thermal conductivity at room temperature (approximately 25°C) of 3.30 W/mK.

Example 4

The same operation as in Example 1 was carried out excepting that 1.537 g of CuO (Manufactured by Kojundo Chemical Laboratory Co., Ltd.), 2.912 g of SnO$_2$ (Manufactured by Kojundo Chemical Laboratory Co., Ltd.), 6.139 g of La$_2$O$_3$ (Manufactured by Kojundo Chemical Laboratory Co., Ltd.) and 0.143 g of SrCO$_3$ (trade name: SW-K, manufactured by Sakai Chemical Industry Co., Ltd.) were used as raw materials to obtain a sintered body 4. The properties of the sintered body 4 were shown in Table 1.

Example 5

The same operation as in Example 1 was carried out excepting that 1.537 g CuO of (Manufactured by Kojundo Chemical Laboratory Co., Ltd.), 2.767 g of SnO$_2$ (Manufactured by Kojundo Chemical Laboratory Co., Ltd.),

Table 1    Properties of sintered body

|  |  | metal element ratio | crystal structure |
|---|---|---|---|
| Example 1 | Sintered body 1 | La:Cu:Sn = 2:1:1 | perovskite |
| Example 2 | Sintered body 2 | La:Ca:Cu:Sn = 1.95:0.05:1:1 | perovskite |
| Example 3 | Sintered body 3 | La:Ba:Cu:Sn = 1.95:0.05:1:1 | perovskite |
| Example 4 | Sintered body 4 | La:Sr:Cu:Sn = 1.95:0.05:1:1 | perovskite |
| Example 5 | Sintered body 5 | La:Cu:Sn:Mg = 2:1:0.95:0.05 | perovskite |

Table 1    Properties of sintered body (continued)

|  |  | 473 K | | |
|---|---|---|---|---|
|  |  | Seebeck coefficient | electric conductivity | power factor |
|  |  | μV/K | S/m | W/mK$^2$ |
| Example 1 | sintered body 1 | 615 | 3.3 | $1.2 \times 10^{-6}$ |
| Example 2 | sintered body 2 | 271 | $2.2 \times 10^{2}$ | $1.6 \times 10^{-5}$ |
| Example 3 | sintered body 3 | 240 | $2.5 \times 10^{2}$ | $1.4 \times 10^{-5}$ |
| Example 4 | sintered body 4 | 213 | $4.0 \times 10^{2}$ | $1.8 \times 10^{-5}$ |
| Example 5 | sintered body 5 | 441 | $3.8 \times 10^{1}$ | $7.4 \times 10^{-6}$ |

Table 1    Properties of sintered body (continued)

| | | 873 K | | |
|---|---|---|---|---|
| | | Seebeck coefficient | electric conductivity | power factor |
| | | $\mu$V/K | S/m | W/mK$^2$ |
| Example 1 | sintered body 1 | 348 | $1.9 \times 10^1$ | $2.3 \times 10^{-6}$ |
| Example 2 | sintered body 2 | 166 | $4.6 \times 10^2$ | $1.3 \times 10^{-5}$ |
| Example 3 | sintered body 3 | 171 | $4.8 \times 10^2$ | $1.4 \times 10^{-5}$ |
| Example 4 | sintered body 4 | 135 | $6.9 \times 10^2$ | $1.3 \times 10^{-5}$ |
| Example 5 | sintered body 5 | 296 | $1.2 \times 10^2$ | $1.3 \times 10^{-5}$ |

Industrial Applicability

According to the present invention, a thermoelectric conversion material with stable thermoelectric conversion properties such as power factor in air at high-temperature is provided. The thermoelectric conversion material is useful for thermoelectric conversion power generation which is expected as environment-conservative electrical power generation.

**Claims**

1.   A thermoelectric conversion material comprising a mixed metal oxide comprising $M^1$, $M^{2A}$ and $M^{2B}$ as metal elements at a molar ratio of $M^1$:$M^{2A}$:$M^{2B}$ of 2:1:1 and having a perovskite crystal structure,
wherein $M^1$ represents at least one $M^{1A}$ selected from the group consisting of La, Y and lanthanoid elements, or a combination of $M^{1A}$ and at least one $M^{1B}$ selected from among alkaline earth metal elements,
$M^{2A}$ represents at least one selected from the group consisting of metal elements each of which can have an atomic valence of 2,
$M^{2B}$ represents at least one selected from the group consisting of metal elements each of which can have an atomic valence of 4,
$M^1$, $M^{2A}$ and $M^{2B}$ are different from one another, and each of $M^{2A}$ and
$M^{2B}$ may contain a doping element.

2.   The material according to Claim 1, wherein $M^{1A}$ represents at least one selected from the group consisting of La, Y, Ce, Pr, Nd, Pm, Sm, Eu and Gd.

3.   The material according to Claim 2, wherein $M^{1A}$ represents La.

4.   The material according to Claim 1, wherein $M^{2A}$ represents at least one selected from the group consisting of Cu, Ni, Zn and Ag.

5.   The material according to Claim 4, wherein $M^{2A}$ represents Cu.

6.   The material according to Claim 1, wherein $M^{2B}$ represents at least one selected from the group consisting of Ti, V, Cr, Mn, Fe, Co, Zr, Nb, Mo, Tc, Ru, Os, Ir, Pt, Au and Sn.

7.   The material according to Claim 6, wherein $M^{2B}$ represents at least one selected from the group consisting of Sn, Ti and Mn.

8.   The material according to Claim 1, wherein the material has a shape of sintered body and has a relative density of not less than 60%.

9.   The material according to Claim 8, wherein its surface is coated with a gas barrier film.

**10.** A thermoelectric conversion device comprising the material as described in any of Claims 1 to 10.

Fig. 1

## INTERNATIONAL SEARCH REPORT

| | International application No. |
|---|---|
| | PCT/JP2007/073262 |

A.  CLASSIFICATION OF SUBJECT MATTER
*H01L35/22*(2006.01)i, *C04B35/50*(2006.01)i

According to International Patent Classification (IPC) or to both national classification and IPC

B.  FIELDS SEARCHED

Minimum documentation searched (classification system followed by classification symbols)
H01L35/22, C04B35/50

Documentation searched other than minimum documentation to the extent that such documents are included in the fields searched
    Jitsuyo Shinan Koho           1922-1996   Jitsuyo Shinan Toroku Koho   1996-2008
    Kokai Jitsuyo Shinan Koho   1971-2008   Toroku Jitsuyo Shinan Koho   1994-2008

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X | JP 2003-008086 A  (Idemitsu Kosan Co., Ltd.), 10 January, 2003 (10.01.03), Claims 1, 3 (Family: none) | 1-3 |

☐  Further documents are listed in the continuation of Box C.　　☐  See patent family annex.

| | |
|---|---|
| *     Special categories of cited documents: | "T"  later document published after the international filing date or priority date and not in conflict with the application but cited to understand the principle or theory underlying the invention |
| "A"  document defining the general state of the art which is not considered   to be of particular relevance | |
| "E"  earlier application or patent but published on or after the international filing date | "X"  document of particular relevance; the claimed invention cannot be considered novel or cannot be considered to involve an inventive step when the document is taken alone |
| "L"  document which may throw doubts on priority claim(s) or which is cited to establish the publication date of another citation or other special reason (as specified) | "Y"  document of particular relevance; the claimed invention cannot be considered to involve an inventive step when the document is combined with one or more other such documents, such combination being obvious to a person skilled in the art |
| "O"  document referring to an oral disclosure, use, exhibition or other means | |
| "P"  document published prior to the international filing date but later than the priority date claimed | "&"  document member of the same patent family |

| Date of the actual completion of the international search | Date of mailing of the international search report |
|---|---|
| 21 February, 2008 (21.02.08) | 04 March, 2008 (04.03.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

## INTERNATIONAL SEARCH REPORT

| | International application No. |
|---|---|
| | PCT/JP2007/073262 |

---

**Box No. II    Observations where certain claims were found unsearchable (Continuation of item 2 of first sheet)**

This international search report has not been established in respect of certain claims under Article 17(2)(a) for the following reasons:

1. ☐  Claims Nos.:
    because they relate to subject matter not required to be searched by this Authority, namely:

2. ☐  Claims Nos.:
    because they relate to parts of the international application that do not comply with the prescribed requirements to such an extent that no meaningful international search can be carried out, specifically:

3. ☐  Claims Nos.:
    because they are dependent claims and are not drafted in accordance with the second and third sentences of Rule 6.4(a).

---

**Box No. III    Observations where unity of invention is lacking (Continuation of item 3 of first sheet)**

This International Searching Authority found multiple inventions in this international application, as follows:
    See extra sheet.

1. ☐  As all required additional search fees were timely paid by the applicant, this international search report covers all searchable claims.

2. ☐  As all searchable claims could be searched without effort justifying additional fees, this Authority did not invite payment of additional fees.

3. ☐  As only some of the required additional search fees were timely paid by the applicant, this international search report covers only those claims for which fees were paid, specifically claims Nos.:

4. ☒  No required additional search fees were timely paid by the applicant.   Consequently, this international search report is restricted to the invention first mentioned in the claims; it is covered by claims Nos.:
        1-3

**Remark on Protest**

the

☐  The additional search fees were accompanied by the applicant's protest and, where applicable, payment of a protest fee.

☐  The additional search fees were accompanied by the applicant's protest but the applicable protest fee was not paid within the time limit specified in the invitation.

☐  No protest accompanied the payment of additional search fees.

Form PCT/ISA/210 (continuation of first sheet (2)) (April 2007)

**INTERNATIONAL SEARCH REPORT**

International application No.

PCT/JP2007/073262

Continuation of Box No.III of continuation of first sheet(2)

Where a group of inventions is claimed in one and the same international application, the requirement of unity of invention (PCT Rule 13.1) shall be fulfilled only when there is a technical relationship among those inventions involving one or more of the same or corresponding special technical features (i.e., those technical features that define a contribution which each of the claimed inventions, considered as a whole, makes over the prior art) as defined in PCT Rule 13.2.

In the present case, a common technical feature among the inventions of claims 1-3, the inventions of claims 4-5, the inventions of claims 6-7, the inventions of claims 8-9 and the invention of claim 10 resides in a matter described in claim 1.

On the other hand, claims 1 and 3 of Document 1: JP 2003-008086 A (Idemitsu Kosan Co., Ltd.) (10 January, 2003 (10.01.03)) describe the invention of claim 1 of the present application.

That is, the combination of $z=0.5$, $q=0.5$ and $x=1$ in the invention of claim 1 of Document 1 corresponds to the invention of claim 1 of the present application.

Consequently, the matter described in claim 1 can be regarded as a technical feature which is already known at the time of filing the present international application. Therefore, the matter cannot be regarded as a technique that makes a contribution over the prior art, and therefore cannot be regarded as a special technical feature as defined in the above-mentioned rule.

Further, there is found no other same or corresponding special technical feature among these inventions.

For the above-stated reasons, it cannot be considered that there is any same or corresponding special technical feature among the above-mentioned inventions of the present application. Therefore, the inventions of the claims of the present international application do not comply with the requirement of unity of invention as defined in PCT Rule 13.1.

Form PCT/ISA/210 (extra sheet) (April 2007)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001512910 A
- JP 8186293 A
- JP 8231223 A
- JP 5315657 A